# Europäisches Patentamt

## European Patent Office

## Office européen des brevets

(19)

(11) Veröffentlichungsnummer: **0 022 450**
A1

(12) ## EUROPÄISCHE PATENTANMELDUNG

(21) Anmeldenummer: 80101949.8

(22) Anmeldetag: 11.04.80

(51) Int. Cl.³: **G 01 R 31/36,** H 01 M 10/48

(30) Priorität: 03.07.79 DE 2926716

(43) Veröffentlichungstag der Anmeldung: **21.01.81**
**Patentblatt 81/3**

(84) Benannte Vertragsstaaten: **AT BE CH DE FR GB IT LI NL**

(71) Anmelder: **ROBERT BOSCH GMBH, Postfach 50,**
**D-7000 Stuttgart 1 (DE)**

(72) Erfinder: **Hollenberg, Horst, Robert-Leicht-Strasse 28,**
**D-7000 Stuttgart 80 (DE)**
Erfinder: **Meyer-Staufenbiel, Torsten, Brucknerweg 4,**
**D-7157 Ditzingen 5 (DE)**

(54) **Prüfverfahren für Gleichstromquellen wie Akkumulatoren und Prüfgerät dafür.**

(57) Es wird ein Prüfverfahren und ein Prüfgerät zur Durchführung dieses Prüfverfahrens für Gleichstromquellen, wie Akkumulatoren, Batterien angegeben, welches durch einen einzigen Prüfvorgang und ohne zusätzliches Aufladen der zu prüfenden Gleichstromquelle (10) (Prüfling) ein eindeutiges Erkennen des Zustands des Prüflings ermöglicht, wobei gleichzeitig angegeben wird, ob für einen «schlechten Zustand» des Prüflings dessen Entladung oder dessen physikalischer Zustand (Speichervermögen) ursächlich ist. Hierzu mißt man den Wechselstrominnenwiderstand $(R_S)$ und die Leerlaufspannung $(U_B)$ des Prüflings (10) und gewinnt durch Paarung der gemessenen Werte der Leerlaufspannung $U_B$ einerseits und des Innenwiderstands $R_{\bar{S}}$ anderseits in einander zugeordneten charakteristischen funktionellen Verknüpfungen der Leerlaufspannung in Abhängigkeit von der Ampere-Stunden-Kapazität $[U_{\bar{B}} = f$ (Ah)] bzw. des Wechselstrominnenwiderstandes in Abhängigkeit von der Ampere-Stunden-Kapazität $[R_{\bar{s}} = f$ (Ah)] für jeweils unterschiedliche physikalische Zustände (Speichervermögen) einer Gleichstromquelle des gleichen Typs wie der Prüfling (10) eine getrennte Aussage über Ladezustand einerseits und Speichervermögen anderseits.

Röser

R. 5572

8.6.1979

ROBERT BOSCH GMBH, 7000 Stuttgart 1

Prüfverfahren für Gleichstromquellen, wie Akkumulatoren, Batterien oder dergl., und Prüfgerät

## Stand der Technik

Die Erfindung geht aus von einem Prüfverfahren für Gleichstromquellen, wie Akkumulatoren, Batterien od.dgl. nach der Gattung des Hauptanspruchs.

Bei einem in einem bekannten Prüfgerät angewandten Verfahren ermittelt man aus dem gemessenen Wechselstrominnenwiderstand der zu prüfenden Gleichstromquelle, kurz Prüfling genannt, das Reziproke des Wechselstrominnenwiderstands und gibt dieses zur Anzeige auf ein Meßgerät. Da der reziproke Wechselstrominnenwiderstand des Prüflings proportional seiner dynamischen Leistung ist und diese - wie gefunden wurde - etwa die elektrische Energie wiedergibt, die in dem Prüfling tatsächlich gespeichert ist, stellt der angezeigte Wert des reziproken Wechselstrominnenwiderstands ein Maß für den Zustand des Prüflings dar.

- 2 -

Nun hat sich gezeigt, daß die dynamische Leistung z.B.
eines Akkumulators oder einer Batterie für ein Kraftfahrzeug
sowohl mit zunehmender Entladung als auch mit zunehmender Verschlechterung des physikalischen Zustands
- durch Alterung, Sulfatierung etc. - erheblich absinkt.
Unter physikalischem Zustand wird hier das Speichervermögen des Akkumulators oder der
Batterie verstanden. Z.B. nimmt die dynamische Leistung
während der Entladung des Akkumulators
oder der Batterie aus dem voll geladenen Zustand bis
zum Zustand der völligen Entladung um den Faktor 3 - 4
ab. Um den Faktor 3 - 10 nimmt auch die dynamische
Leistung eines Akkumulators oder einer Batterie, der oder
die während mehrerer Monate entladen wurde oder war,
bevor sie wieder geladen wurde, infolge erhöhter
Sulfatierung ab.

Bei diesem bekannten Prüfverfahren bzw. Prüfgerät
erhält man lediglich eine Aussage über den tatsächlichen
Ist-Zustand des Prüflings, wobei man nicht weiß, ob
dieser z.B. "schlechte" Ist-Zustand des Prüflings dadurch
verursacht ist, daß der Prüfling lediglich zumindest
teilweise entladen ist oder durch Alterung, Sulfatierung
oder andere Umstände sein ursprüngliches Speichervermögen
teilweise oder ganz verloren hat. Dies führt dazu, daß in
jedem Fall bei Feststellung eines "schlechten" Zustands
des Prüflings dieser aufgeladen wird, selbst wenn sich
ein Aufladen des Prüflings wegen seines äußerst schlechten
physikalischen Zustands, beispielsweise totalen Verlustes
seines Speichervermögens, nicht
mehr lohnt. Erst dieses Aufladen des Prüflings und sein
erneutes Prüfen läßt erkennen, daß der "schlechte" Ist-
Zustand des Prüflings durch seinen schlechten physikalischen
Zustand verursacht ist; denn durch das Aufladen wird die

- 3 -

mögliche andere Ursache für den "schlechten" Ist-Zustand,
nämlich die teilweise Entladung, beseitigt. Das in
vielen Fällen unnütze Aufladen einer defekten Batterie
zum Zwecke des Feststellens ihres Defektseins bedeutet
einen unnötigen und nicht unbeträchtlichen Zeit- und
Kostenaufwand.

## Vorteile der Erfindung

Das erfindungsgemäße Prüfverfahren mit den kennzeichnenden
Merkmalen des Hauptanspruchs hat demgegenüber den Vorteil, daß der Prüfling nicht aufgeladen werden muß, um
seinen physikalischen Zustand, d.h. sein tatsächlich
vorhandenes Speichervermögen, zu ermitteln. Bei dem erfindungsgemäßen Prüfverfahren wird sowohl der Ladezustand
des Prüflings, z.B. voll, teilweise entladen, leer, als
auch der physikalische Zustand des Prüflings ermittelt,
so daß der Prüfende gleich weiß, ob sich ein Aufladen des
Prüflings aufgrund seines physikalischen Zustands noch
lohnt oder nicht. Damit können die Kosten für eine evtl.
unnötige Aufladung und der damit verbundene Zeitaufwand
eingespart werden.

Das in Anspruch 2 angegebene Prüfgerät zur Durchführung
des Verfahrens hat neben den bereits vorstehend genannten
Vorteilen noch den weiteren Vorteil der einfachen Handhabung und Bedienbarkeit. Der Prüfende braucht lediglich
den Prüfling an das Prüfgerät anzuschließen und einen
Prüfvorgang zu starten. Das Prüfergebnis wird ihm an
der Anzeigevorrichtung ausgegeben, und zwar einerseits
der physikalische Zustand des Prüflings und andererseits
dessen Ladezustand. Mit einem Blick kann der Prüfende
also erkennen, ob der Prüfling geladen werden muß oder

- 4 -

nicht und ob der qualitative Zustand des Prüflings
seine Aufladung rechtfertigt oder nicht.

Durch die in den weiteren Ansprüchen aufgeführten Maßnahmen sind vorteilhafte Weiterbildungen und Verbesserungen
des Prüfgeräts möglich. Besonders vorteilhaft sind dabei
die Maßnahmen nach Anspruch 10 oder 11, da dadurch sowohl
das Bauvolumen des Prüfgerätes sehr klein bemessen werden
kann als auch die Herstellungskosten für das Prüfgerät
niedrig gehalten werden können.

Zeichnung

Ein Ausführungsbeispiel der Erfindung ist in der Zeichnung
dargestellt und in der nachfolgenden Beschreibung näher
erläutert. Es zeigen

Fig. 1    eine schematische Darstellung von
          funktionellen Verknüpfungen der Leerlaufspannung $U_B$ in Abhängigkeit von der Ampere-
          Stunden-Kapazität Ah bzw. des Wechselstrominnenwiderstands $R_S$ in Abhängigkeit von der
          Ampere-Stunden-Kapazität Ah für eine KFZ-
          Batterie bestimmten Typs,

Fig. 2    ein Blockschaltbild des Aufbaus eines Prüfgeräts zum Prüfen einer KFZ-Batterie.

Beschreibung des Ausführungsbeispiels

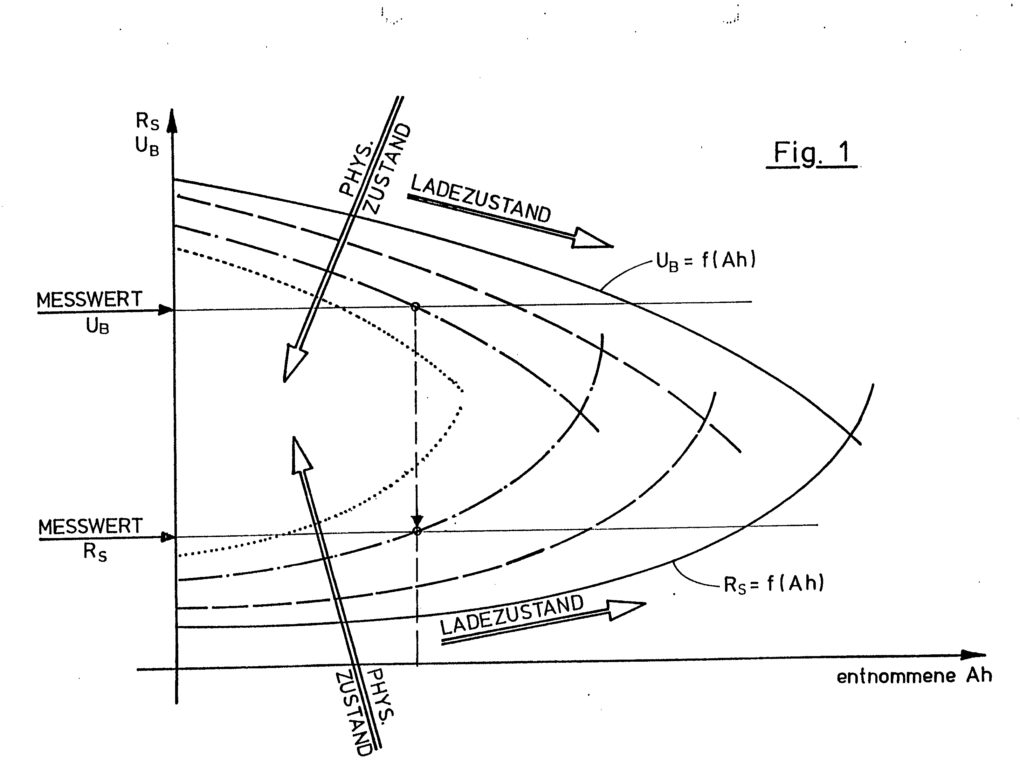

Zunächst wird anhand der Fig. 1 das Prüfverfahren für
Gleichstromquellen, wie Akkumulatoren, Batterien od.dgl., anhand
der Prüfung einer Kraftfahrzeug-Batterie (KFZ-Batterie)
kurz umrissen, welches dann in der weiteren Beschreibung
des Prüfgeräts noch näher erläutert wird. Bei dem Prüfver-

- 5 -

fahren bestimmt man zunächst den Wechselstrominnenwiderstand $R_S$ der zu prüfenden KFZ-Batterie, im
folgenden kurz Prüfling genannt, und mißt deren Gleichstrom-Leerlaufspannung $U_B$. Diese beiden Meßwerte paart
man - wie aus Fig. 1 ersichtlich - in einander zugeordneten charakteristischen funktionellen Verknüpfungen
der Leerlaufspannung $U_B$ in Abhängigkeit von der Ampere-
Stundenkapazität Ah bzw. des Wechelstrominnenwiderstandes $R_S$ in Abhängigkeit von der Ampere-Stunden-Kapazität Ah für jeweils unterschiedliche physikalische
Zustände einer KFZ-Batterie des gleichen Typs wie der
Prüfling. Solche charakteristischen funktionellen Verknüpfungen lassen sich als Kennlinienfelder Fig.1 oder
auch als angenäherte mathematische Funktionen darstellen.

In Fig. 1 sind für eine KFZ-Batterie, die von gleichem
Typus wie der Prüfling ist, also gleiche Nennkapazität,
Nennspannung und gleichen strukturellen Aufbau (z.B.
Bleiakkumulator oder Nickel-Cadmium-Akkumulator) aufweist,
dessen charakteristische funktionelle Verknüpfungen $U_B$ =
f (Ah) und $R_S$ = f (Ah) als Kennlinienfeld dargestellt.
Einander zugeordnete funktionelle Verknüpfungen sind jeweils in gleicher Strichart gekennzeichnet. Dabei
stellen die ausgezogen dargestellten Kennlinien die entsprechenden charakteristischen funktionellen Verknüpfungen
für eine neue Batterie dar. Man erkennt, daß mit zunehmender Entladung die Gleichstrom-Leerlaufspannung $U_B$
der Batterie abnimmt und der Wechselstrominnenwiderstand
zunimmt. Für die gleiche, jedoch gealterte Batterie ergeben sich die charakteristischen funktionellen Verknüpfungen gemäß den strichlinierten Kennlinien. Ist die
Batterie noch stärker gealtert, d.h. hat durch fortschreitende Sulfatierung ihr Speichervermögen weiter
abgenommen, so ergeben sich die charakteristischen

- 6 -

funktionellen Verknüpfungen gemäß den strichpunktierten Kennlinien. Die gleiche Batterie in relativ schlechtem physikalischen Zustand ist in ihren charakteristischen funktionellen Verknüpfungen durch die punktierten Kennlinien gekennzeichnet. Man sieht, daß mit Verschlechterung des physikalischen Zustands der Batterie sowohl die Leerlaufspannung $U_B$ absinkt als auch gleichzeitig der Wechselstrominnenwiderstand $R_S$ zunimmt. Die einzelnen Kennlinien $U_B = f$ (Ah) und $R_S = f$ (Ah) behalten dabei im wesentlichen ihren vorstehend beschriebenen charakteristischen Verlauf bei.

Paart man nunmehr die beiden ermittelten Meßwerte für Leerlaufspannung $U_B$ und Wechselstrominnenwiderstand $R_S$ in einander zugeordneten charakteristischen funktionellen Verknüpfungen $U_B = f$ (Ah) und $R_S = f$ (Ah) für die gleiche entnommene Ampere-Stunden-Kapazität Ah (in Fig. 1 durch die Schnittpunkte der Meßwertlinien mit den zugeordneten Kennlinien dargestellt), so erhält man eine getrennte Aussage einerseits über den Ladezustand des Prüflings (entnommene Ampere-Stunden-Kapazität Ah) und andererseits über den physikalischen Zustand bzw. das Speichervermögen des Prüflings (strichpunktierte Kennlinie = z.B.relativ schlecht).

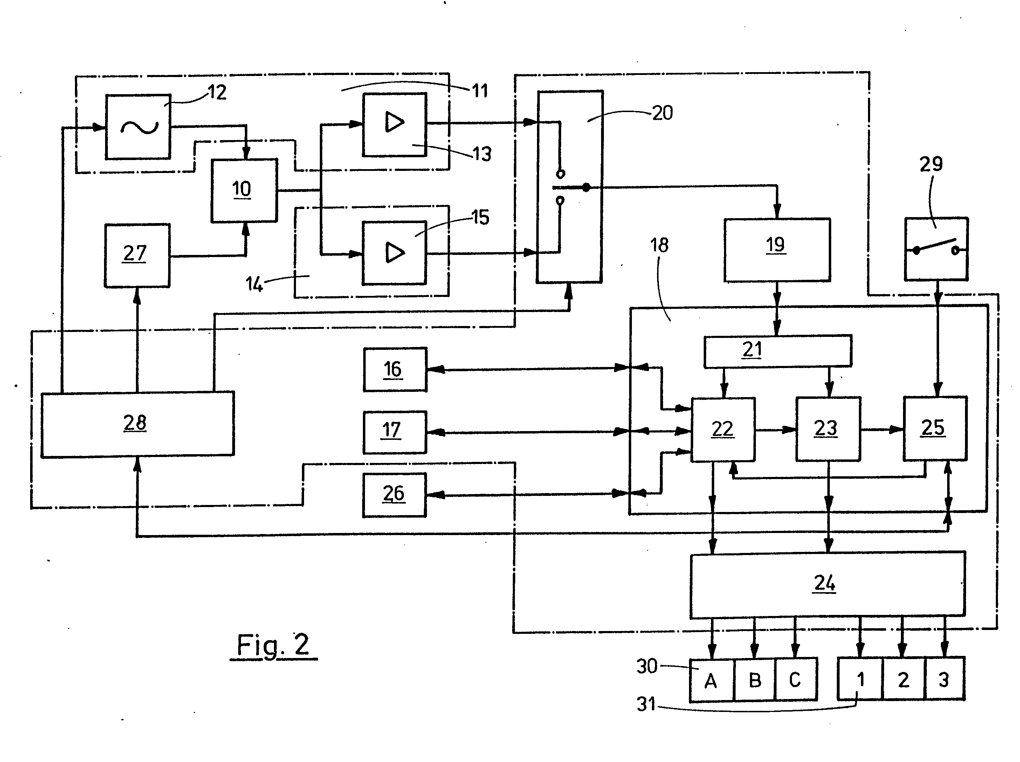

Das Prüfgerät für Gleichstromquellen, wie Akkumulatoren, Batterien oder dergleichen, zur Durchführung des vorstehend beschriebenen Prüfverfahrens ist schematisch als Blockschaltbild in Fig. 2 dargestellt. Dabei ist die an das Prüfgerät zur Prüfung anzuschließende KFZ-Batterie, im folgenden Prüfling genannt, mit 10 bezeichnet.

Das Prüfgerät weist eine Widerstandsmeßeinrichtung 11 zum Messen des Wechselstrominnenwiderstands des Prüflings auf. Diese besteht aus einem Konstantstromgenerator 12
und einem Spannungsverstärker 13. Der Konstantstromgenerator 12 wird an die Klemmen des Prüflings 10 angeschlossen und speist diesen mit einem konstanten Strom
von sehr geringer Stromstärke und konstanter Frequenz,
vorzugsweise 100 Hz. Der Spannungsverstärker 13 ist als
ein auf die Frequenz des Konstantstromgenerators 12 abgestimmter selektiver Verstärker ausgebildet, der noch eine
Gleichstromsperre enthält. Der Spannungsverstärker 13
ist ebenfalls an die Klemmen des Prüflings 10 angeschlossen
und erfaßt und verstärkt die an den Klemmen des Prüflings
10 abfallende Wechselspannung.

Das Prüfgerät weist ferner eine Spannungsmeßeinrichtung 14
auf, die im wesentlichen aus einem Gleichspannungsverstärker 15 besteht. Dieser ist ebenfalls an die Klemmen
des Prüflings 10 angeschlossen. Zur Verbesserung der
Spannungsmessung kann der Gleichspannungsverstärker 15
noch eine Offsetspannung erhalten.

In dem Prüfgerät ist weiter ein erster Speicher 16 vorhanden, in dem    die charakteristischen funktionellen
Verknüpfungen der Leerlaufspannung $U_B$ und der Ampere-
Stunden-Kapazität Ah zumindest einer KFZ-Batterie des
gleichen Typs wie der Prüfling für jeweils ausgewählte
unterschiedliche physikalische Zustände dieser abgespeichert
sind.    Wie vorstehend bereits erwähnt, wird hier unter
physikalischem Zustand das Speichervermögen der Batterie
verstanden, das durch Alterungsprozess, insbesondere infolge von Sulfatierung oder Masseanfall oder durch andere Umstände gegenüber einer neuen intakten Batterie abnehmen kann. Um das
Prüfgerät universell verwenden zu können, sind die vorstehend genannten charakteristischen funktionellen Verknüpfungen nicht nur für einen Batterietyp, sondern für

- 8 -

alle gängigen Batterietypen abgespeichert. In gleicher
Weise werden in einem zweiten Speicher 17 die
charakteristischen funktionellen Verknüpfungen des
Wechselstrominnenwiderstands $R_S$ und der Ampere-Stunden-
Kapazität Ah für jeweils die gleichen ausgewählten Zustände wie die funktionellen Verknüpfungen im ersten
Speicher 16 abgespeichert. Die funktionellen Verknüpfungen
können dabei entweder als Kennlinienfelder oder als angenäherte
mathematische Funktionen gespeichert sein. Vorteilhaft
ist es, die einzelnen charakteristischen funktionellen
Verknüpfungen zu normieren, und zwar vorzugsweise auf
die Nennwerte,um somit die Anzahl der abzuspeicherten
Verknüpfungen zu reduzieren. Für alle Batterien der
gleichen Art, Blei- oder alkalische Akkumulatoren, aber
unterschiedlicher Nennkapazität und Nennspannung reicht dann
die Abspeicherung eines einzigen Kennlinienfeldes oder weniger
mathematischer Funktionen jeweils für verschiedene physikalische Zustände aus.

Mit den beiden Meßeinrichtungen, also Widerstandsmeßeinrichtung 11 und Spannungsmeßeinrichtung 14, und mit
den Speichern 16,17 ist ein Operator 18 verbunden, der
vorzugsweise digital arbeitet und als Mikroprozessor
ausgebildet sein kann. Da die Meßwerte der Meßeinrichtungen
11, 14 als analoge Signale ausgegeben werden, müssen
diese zur Verarbeitung im Operator 18 in Digitalwerte
umgesetzt werden. Hierzu dient ein zwischen den Meßeinrichtungen 11 und 15 und dem Operator 18 eingeschalteter
Analog-Digital-Wandler 19. Um mit einem einzigen Analog-
Digital-Wandler 19 auszukommen, ist diesem ein Analogumschalter 20 vorgeschaltet, der abwechselnd ein analoges
Meßwertsignal von der Widerstandsmeßeinrichtung 11 bzw.
der Spannungsmeßeinrichtung 14 dem Analog-Digital-Wandler
19 zuführt. Der Analogumschalter 20 ist mit seinen beiden

- 9 -

Eingängen an den Ausgängen der Spannungsverstärker 13,
15 angeschlossen und sein Ausgang ist mit dem Eingang
des Analog-Digital-Wandlers verbunden. Die dem Operator
18 über den Analog-Digital-Wandler 19 zugeführten digitalen Meßwertsignale werden in einem Zwischenspeicher 21
des Operators 18 bis zur Beendigung eines Prüfvorgangs
abgespeichert.

Der Operator 18 weist eine Recheneinheit 22 und einen
Vergleicher 23 auf. Die Recheneinheit 22 errechnet bzw.
ermittelt zu der an dem Eingang des Operators 18 bzw.
in dessen Zwischenspeicher 21 als Signal anstehenden gemessenen Leerlaufspannung des Prüflings 10 aus den abgespeicherten Verknüpfungen einen zugeordneten Wert des
Wechselstrominnenwiderstands $R_S$ und gibt diesen als Ausgangssignal an den Vergleicher 23. Über einen Ausgangs des
Operators 18 ist der Vergleicher 23 mit einer Anzeigevorrichtung 24 verbunden. Außer dem Ausgangssignal der
Recheneinheit 22 wird dem Vergleicher auch noch der am
Operator 18 bzw. in dessen Zwischenspeicher 21 als
Signal anstehende Wert des gemessenen Wechselstrominnenwiderstandes als Eingangssignal zugeführt. Der Vergleicher 23
arbeitet nun derart, daß er bei Koinzidenz oder im wesentlichen annähernder Koinzidenz seiner beiden Eingangssignale ein Ausgangssignal an die Anzeigevorrichtung 24
abgibt,  die ihrerseits eine Anzeigefunktion einschaltet.

Der Operator 18 weist außerdem noch ein mit dem Vergleicher
23 und der Recheneinheit 22 verbundenes Steuerteil 25 auf.
Dieses Steuerteil 25 ist derart aufgebaut und mit dem
Vergleicher 23 und der Recheneinheit 22 verknüpft, daß bei
Nichtvorliegen der Koinzidenz bzw. annähernden Koinzidenz
der Eingangssignale des Vergleichers 23 dieser an das
Steuerteil 25 ein Signal abgibt, das hier ein Steuersignal auslöst. Dieses Steuersignal des Steuerteils 25 veranlaßt die Recheneinheit 22 einen Rechen- bzw. Bestimmungszyklus, wie vorstehend beschrieben, zu durchlaufen, wobei sie am Ende eines jeden Zyklus ein Ausgangssignal an den Vergleicher 23 abgibt. Diese Rechen-
oder Bestimmungszyklen sind aber nicht identisch, sondern
erfolgen jeweils mit den abgespeicherten Verknüpfungen
für einen bestimmten physikalischen Zustand der Batterie.
Bei jedem Zyklus wird eine abgespeicherte Verknüpfung
für einen bestimmten physikalischen Zustand der Batterie
aus dem Speicher 16,17 ausgelesen und verarbeitet.
Zweckmäßigerweise beginnt der erste Zyklus mit den Verknüpfungen für den besten physikalischen Zustand der
Batterie.

Zur Eingabe der Kenndaten des Prüflings 10 in die Recheneinheit 22 ist mit dem Operator 18 eine Dateneingabevorrichtung 26 verbunden. Über diese Dateneingabevorrichtung
werden die Nennkapazität, die Nennspannung und die Art
des Prüflings 10, z.B. Blei- oder Nickel-Cadmium-Akkumulator,
eingegeben. Darüberhinaus können noch zur Ausschaltung
von Temperatureinflüssen die Temperatur des Prüflings
eingegeben werden.

Zur Kompensation von Meßfehlern , die durch die Oberflächenladung frischgeladener Prüflinge oder durch fehlerhafte Zellenverbinder im Prüfling hervorgerufen werden
können, ist noch zusätzlich ein Hochstromimpulsgenerator
27 mit dem Prüfling 10 verbunden, der vor Beginn des
eigentlichen Prüfvorgangs dem Prüfling 10 mit einem Hochstromimpuls belastet. Dieser Hochstromimpuls hat z.B.
eine Stromstärke in Höhe des Belastungsstromes des Prüflings und
dauert einige Sekunden. Mit diesem Hochstromimpuls wird
einerseits die Oberflächenladung eines frisch geladenen

- 11 -

Prüflings abgebaut und andererseits dessen Zellenverbinder getestet. Sind diese bereits sehr schlecht,
so werden sie durch den Hochstromimpuls vollständig
zerstört.

Das Prüfgerät ist mit einem Zeitschalter 28 ausgerüstet,
der das "Timing"für die Einzelvorgänge während des Prüfvorgangs bestimmt. Der Zeitschalter 28 ist mit dem Hochstromimpulsgenerator 27, dem Konstantstromgenerator 12,
dem Analogumwandler 20 und dem Operator 18 verbunden.
Ein von einem Starter 29 dem Operator 18 zugeführter
Startimpuls für den Prüfvorgang sind setzt den Zeitschalter 28 in Tätigkeit. Dieser bewirkt die Ein- und
Ausschaltung des Hochstromimpulsgenerators 27 und des
Konstantstromgenerators 12 sowie die Umschaltung des
Analogumschalters 20 zur wechselweisen Übertragung der
analogen Meßwertsignale am Ausgang der Spannungsverstärker 13 und 15 der Widerstandsmeßeinrichtung 11 bzw.
der Spannungsmeßeinrichtung 14 auf den Analog-Digital-
Wandler 19.

Es ist möglich, den Operator 18, die beiden Speicher 16
und 17, die im übrigen von einem einzigen Speicher gebildet
sein können, den Analog-Digital-Wandler 19, den Analogumschalter 20, den Zeitschalter 28 und zumindest Teile
der Anzeigevorrichtung 24 zu einem sogenannten "Ein-
Chip —Mikroprozessor"zusammenzufassen . Dies führt zu
einer beträchtlichen Kosten- und Volumenreduzierung für
das Prüfgerät.

Die Anzeigevorrichtung 24 weist getrennte Anzeigefelder 30
und 31 einerseits für die physikalische Zustandsanzeige,
in Fig. 2 mit A, B und C gekennzeichnet, und andererseits
für die Ladezustandsanzeige, in Fig. 2 mit 1, 2, 3 gekenn-

- 12 -

zeichnet, auf. Die Anzeigefelder 30, 31 werden über
die Anzeigevorrichtung 24 von dem Operator 18 selektiv
angesteuert. Anstelle der Anzeigefelder 30,31 können
an die Anzeigevorrichtung 24     auch eine Digitalanzeige, ein Band aus aufeinanderfolgend aufleuchtenden
Lumineszenzdioden, ein Drucker für Textausgabe oder
dergl. angeschlossen werden.

Die gesamte Stromversorgung des Prüfgerätes erfolgt
über den Prüfling 10, so daß das Prüfgerät unabhängig
von vorhandenen Versorgungsnetzen überall eingesetzt
werden kann.

Die Wirkungsweise des vorstehend beschriebenen Prüfgerätes ist wie folgt:

Zunächst ist der Prüfling 10 an das Prüfgerät anzuschließen. Danach hat der Prüfer den Starter  29
zu betätigen. Die Prüfung des Prüflings 10 läuft selbsttätig ab und in der Anzeigevorrichtung 24 leuchtet
jeweils ein Anzeigefeld 30 und ein Anzeigefeld 31 auf,
die den physikalischen Zustand des Prüflings und den
Ladezustand des Prüflings anzeigen. Leuchtet z.B. das
Anzeigefeld 30 mit "A" und Anzeigefeld 31 mit "2" auf,
so bedeutet dies z.B., daß der physikalische Zustand
des Prüflings, also dessen Speichervermögen bestens ist,
es sich hier also um eine neue Batterie handelt, und
daß der Prüfling 10 teilweise entladen ist. Entsprechend
markiert das Anzeigefeld 30 mit "C" einen Prüfling
mit sehr schlechtem Speichervermögen und das Anzeigefeld
31 mit "1" einen vollständig geladenen Prüfling 10.

Bei dem Prüfvorgang spielt sich im einzelnen folgendes
ab: Der Zeitschalter 28 gibt zunächst einen Startimpuls auf den Hochstromimpulsgenerator 27, der wie vorstehend beschrieben, einen Hochstromimpuls auf den
Prüfling 10 gibt. Danach beginnt der eigentliche Prüfvorgang mit Einschalten des Konstantstromgenerators 12,
ebenfalls durch einen Steuerimpuls des Zeitschalters 28.
Der Zeitschalter 28 steuert mit einem weiteren Impuls
den Analogumschalter 20 derart, daß z.B. zunächst die
Widerstandsmeßeinrichtung 11 mit den Analog-Digital-
Wandler 19 verbunden ist. Die Widerstandsmeßeinrichtung 11 mißt den Wechselspannungsabfall an den
Klemmen des Prüflings 10 und gibt diesen als verstärktes Analogsignal an den Analog-Digital-Wandler 19.
Diese führt dem Operator 18 ein entsprechendes digitales
Meßwertsignal des Wechselstrominnenwiderstands des
Prüflings zu, das in dem Zwischenspeicher 21 abgespeichert
wird.

Durch einen weiteren Steuerimpuls des Zeitschalters 28
wird der Analogumschalter 20 umgeschaltet, so daß nunmehr
der Eingang des Analog-Digital-Wandlers 19 mit dem Ausgang
der Spannungsmeßeinrichtung 14 verbunden ist. Die
Klemmen-Gleichspannung des Prüflings 10 wird über den
Gleichspannungsverstärker 15 verstärkt als analoges
Meßwertsignal dem Analog-Digital-Wandler 19 zugeführt,
der ebenfalls ein entsprechendes digitales Meßwertsignal der Leerlaufspannung des Prüflings 10 an den
Operator 18 gibt, wo dieses ebenfalls im Zwischenspeicher 21
abgespeichert wird. Aus der Dateneingabevorrichtung 26
werden die vor Beginn des Prüfvorgangs in diese eingegebenen Kenndaten des Prüflings 10 in die Recheneinheit 22
eingegeben. Mittels dieser Kenndaten liest die Recheneinheit 22 aus den beiden Speichern 16,17 eine charakteristische
funktionelle Verknüpfung der Leerlaufspannung $U_B$ in Abhängigkeit von der Ampere-Stunden-Kapazität Ah ($U_B = f (Ah)$)

- 14 -

und eine zugeordnete charakteristische funktionelle
Verknüpfung des Wechselstrominnenwiderstandes $R_S$ in
Abhängigkeit von der Ampere-Stunden-Kapazität Ah ($R_S$ = f
(Ah) ) einer solchen Gleichstromquelle aus, die vom
gleichen Typ ist wie der Prüfling 10, und zwar für
eine Gleichstromquelle, die den besten physikalischen
Zustand, also max. Speichervermögen, aufweist. Die
Recheneinheit 22 errechnet bzw. ermittelt nunmehr mit
dem gemessenen Wert der Leerlaufspannung des Prüflings
und den abgespeicherten funktionellen Verknüpfungen
einen zugeordneten Wert des Wechselstrominnenwiderstands
und gibt diesen als Ausgangssignal aus, das dem Vergleicher 23 zugeführt wird. Der Vergleicher vergleicht
dieses Ausgangssignal mit dem gemessenen Wert des
Wechselstrominnenwiderstands, der von dem Zwischenspeicher 21 dem Vergleicher 23 zugeführt wird. Es wird
angenommen, daß der Vergleicher 23 zunächst keine
Koinzidenz oder annähernde Koinzidenz der beiden Eingangssignale feststellt, da das Ausgangssignal der Recheneinheit 22 kleiner ist als das Meßwertsignal des Wechselstrominnenwiderstands. Nach dem vorher Gesagten gibt
damit der Vergleicher 23 ein Ausgangssignal an das
Steuerteil 25 ab, das hier wiederum ein Steuersignal auslöst, das zur Recheneinheit 22 gelangt. Das Steuersignal
veranlaßt die Recheneinheit 22 erneut eine charakteristische
funktionelle Verknüpfung $U_B$ = f (Ah) und die zugeordnete
funktionelle Verknüpfung $R_S$ = f (Ah) aus den beiden
Speichern 16 und 17 auszulesen, und zwar jetzt für
einen um eine Stufe verschlechterten physikalischen Zustand der gleichen Gleichstromquelle. Die Rechenheinheit 22
ermittelt mit den nunmehr ausgelesenen funktionellen
Verknüpfungen und dem nach wie vor gleichen Meßwert der
gemessenen Leerlaufspannungs des Prüflings 10 einen neuen
Wert des Wechselstrominnenwiderstand und gibt diesen als Ausgangssignal an den Vergleicher 23. Ist dieses
Ausgangssignal nunmehr annähernd gleich dem Meßwertsignal des Wechselstrominnenwiderstandes, so stellt
der Vergleicher 23 Koinzidenz fest und gibt nach dem
vorher Gesagten einen Impuls an die Anzeigevorrichtung
24 ab. Die Anzahl der von der Recheneinheit 22 durchlaufenen Rechen-oder Bestimmungszyklen ist dabei ein
Maß für den physikalischen Zustand des Prüflings 10,
d.h. je mehr Rechenzyklen die Recheneinheit 22 durchlaufen ist,desto schlechter ist der physikalische Zustand bzw. das Speichervermögen des Prüflings 10.
Sobald ein Ausgangssignal an dem mit der Anzeigevorrichtung 24 verbundenen Ausgang des Vergleichers 23
auftritt, schaltet die Anzeigevorrichtung 24 entsprechend der Zahl der Zyklen der Recheneinheit 22
eines der Anzeigefelder 30 ein, hier z.B. bei zwei
Zyklen der Recheneinheit 22 das Anzeigefeld mit "B".
Dies signalisiert dem Prüfenden, daß der Prüfling 10
zwar ein vermindertes aber noch ausreichendes Speichervermögen ausweist. Da bei der Rechnung bzw. Bestimmung
des Wertes des Wechselstrominnenwiderstandes durch die
Recheneinheit 22 automatisch der Ah-Wert berechnet
oder ermittelt wird, steht dieser über die Verbindung
von Operator 18 und Anzeigevorrichtung 24 an dieser an
und kann bei Auftreten des Ausgangssignals an dem mit
der Anzeigevorrichtung 24 verbundenen Ausgang des Vergleichers 23 das Einschalten eines entsprechenden Anzeigefelds 31, z.B. des Anzeigefelds 31 mit "2",bewirken.
Dem Prüfenden wird damit angegeben, daß der Prüfling 10
bereits teilweise entladen ist.

-.-.-.-.-.-

0022450

R. **5572**
8.6.1979

ROBERT BOSCH GMBH, 7000 Stuttgart 1

Ansprüche

1. Prüfverfahren für Gleichstromquellen, wie Akkumulatoren, Batterien od. dergl., bei welchem man
den Wechselstrominnenwiderstand der zu prüfenden
Gleichstromquelle (Prüfling) als Kenngröße für
deren Zustand mißt, d a d u r c h   g e k e n n -
z e i c h n e t, daß man zusätzlich die Leerlaufspannung des Prüflings (10) mißt und daß man durch
Paarung der gemessenen Werte der Leerlaufspannung
($U_B$) einerseits und des Innenwiderstands ($R_S$) andererseits in einander zugeordneten charakteristischen
funktionellen Verknüpfungen der Leerlaufspannung($U_B$)
in Abhängigkeit von der Ampere-Stunden-Kapazität (Ah)
bzw. des Wechselstrominnenwiderstandes ($R_S$) in Abhängigkeit von der Ampere-Stunden-Kapazität (Ah) für
jeweils unterschiedliche physikalische Zustände einer
Gleichstromquelle des gleichen Typs wie der Prüfling (10)
eine getrennte Aussage über Ladezustand einerseits
und physikalischen Zustand andererseits gewinnt.

- 2 -

2. Prüfgerät für Gleichstromquellen, wie Akkumulatoren, Batterien od. dgl., zur Durchführung des Prüfverfahrens nach Anspruch 1, mit einer den Wechselstrominnenwiderstand des Prüflings messenden Widerstandsmeßeinrichtung und mit einer den Zustand des Prüflings angebenden Anzeigevorrichtung, g e - k e n n z e i c h n e t   d u r c h  eine die Leerlaufspannung des Prüflings (10) messende Spannungsmeßeinrichtung (14), durch einen ersten Speicher (16), in dem die charakteristischen funktionellen Verknüpfungen der Leerlaufspannung $(U_B)$ und der Ampere-Stunden-Kapazität (Ah) zumindest einer Gleichstromquelle des gleichen Typs wie der Prüfling (10) für jeweils ausgewählte, unterschiedliche physikalische Zustände dieser abgespeichert sind, durch einen zweiten Speicher (17), in dem die charakteristischen funktionellen Verknüpfungen des Wechselstrominnenwiderstands $(R_S)$ und der Ampere-Stunden-Kapazität (Ah) zumindest einer Gleichstromquelle des gleichen Typs wie der Prüfling für jeweils die gleichen ausgewählten Zustände dieser abgespeichert sind, durch einen mit der Widerstandsmeßeinrichtung (11), der Spannungsmeßeinrichtung (14) und den Speichern (16,17) verbundenen Operator (18), der eine Recheneinheit (22), die zu der an dem Eingang des Operators (18) als Signal anstehenden gemessenen Leerlaufspannung $(U_B)$ des Prüflings (10) aus den abgespeicherten Verknüpfungen einen zugeordneten Wert des Wechselstrominnenwiderstandes $(R_S)$ errechnet bzw. ermittelt und als Ausgangssignal ausgibt,und einen Vergleicher (23) aufweist, der bei Koinzidenz oder im wesentlichen annähernder Koinzidenz zwischen dem an dem Eingang des Operators (18) als Signal anstehenden gemessenen Wechselstrominnenwiderstand ($R_S$) und dem Ausgangssignal der
Recheneinheit (22) ein Anzeigesignal an die mit
dem Operator (18) verbundene Anzeigevorrichtung (24)
abgibt.

3. Prüfgerät nach Anspruch 2, d a d u r c h   g e -
k e n n z e i c h n e t, daß der Operator (18)
ein Steuerteil (25) aufweist, das derart aufgebaut
und mit dem Vergleicher (23) und der Recheneinheit
(22) verknüpft ist, daß letztere mit jedem Steuersignal
des Steuerteils (25)   einen Rechen- bzw. Bestimmungszyklus durchläuft, wobei aufeinanderfolgende Zyklen
mit jeweils den abgespeicherten Verknüpfungen für
einen bestimmten physikalischen Zustand der Gleichstromquelle erfolgen, die nacheinander, vorzugsweise
beginnend mit den Verknüpfungen für den besten
physikalischen  Zustand, aus den Speichern .(16,17) ausgelesen werden, und im Steuerteil (25) ein Steuersignal
jeweils bei Differenz der Eingangssignale des Vergleichers (23) ausgelöst wird.

4. Prüfgerät nach Anspruch 2 oder 3, d a d u r c h
g e k e n n z e i c h n e t, daß mit dem Operator (18)
eine Dateneingabevorrichtung (26) verbunden ist, mittels
derer die Kenndaten des Prüflings(10), wie Nennspannung,
Nennkapazität, Typenart, in die Recheneinheit (22)
eingebbar sind.

- 4 -

5. Prüfgerät nach einem der Ansprüche 2 - 4, d a -
d u r c h   g e k e n n z e i c h n e t, daß der
Operator (18) einen Zwischenspeicher (21) aufweist,
welcher dessen der gemessenen Leerlaufspannung ($U_B$)
bzw. des gemessenen Wechselstrominnenwiderstandes ($R_S$)
entsprechende Eingangssignale speichert.

6. Prüfgerät nach einem der Ansprüche 2-5, d a d u r c h   g e k e n n -
z e i c h n e t, daß die Spannungsmeßeinrichtung (14)
und die Widerstandsmeßeinrichtung (11) über einen
Analogumschalter (20) und einen Analog-Digital-
Wandler (19) mit dem Operator (18) verbunden sind.

7. Prüfgerät nach einem der Ansprüche 2 - 6, d a d u r c h
g e k e n n z e i c h n e t, daß die Widerstandsmeßeinrichtung (11) einen mit dem Prüfling (10) verbindbaren frequenzkonstanten Konstantstromgenerator (12)
und einen mit dem Prüfling (10) verbindbaren Spannungsverstärker (13) aufweist, der vorzugsweise als ein
auf die Frequenz des Konstantstromgenerators (12)
abgestimmter selektiver Verstärker mit Gleichstromsperre ausgebildet ist.

8. Prüfgerät nach einem der Ansprüche 2 - 7, d a d u r c h
g e k e n n z e i c h n e t, daß die Spannungsmeßeinrichtung (14) einen mit dem Prüfling (10) verbindbaren Gleichspannungsverstärker (15) aufweist, an den
vorzugsweise eine Offsetspannung gelegt ist.

9. Prüfgerät nach einem der Ansprüche 2 - 8, d a d u r c h
g e k e n n z e i c h n e t, daß ein vor Aktivieren der
Meßeinrichtungen (11,14) kurzzeitig einschaltbarer
Hochstromimpulsgenerator (27) vorgesehen ist, der mit
dem Prüfling (10) verbindbar ist.

10. Prüfgerät nach Anspruch 9, d a d u r c h  g e -
k e n n z e i c h n e t, daß ein zeitlich
differierende  Steuerimpulse ausgebender Zeitschalter (28) vorgesehen ist, der mit dem Hochstromimpulsgenerator (27), dem Konstantstromgenerator
(12) und dem Analogumschalter (20) verbunden ist.

11. Prüfgerät nach einem der Ansprüche 2 - 10, d a d u r c h
g e k e n n z e i c h n e t, daß der Operator (18)
als Mikroprozessor ausgebildet ist.

12. Prüfgerät nach Anspruch 10, d a d u r c h  g e k e n n -
z e i c h n e t, daß der Operator (18), die Speicher
(16,17), der Analogumschalter (20), der Analog-
Digital-Wandler (19), der Zeitschalter (28) und zumindest Teile der Anzeigevorrichtung (24) in einem
Ein- Chip-Mikroprozessor  zusammengefaßt sind.

13. Prüfgerät nach einem der Ansprüche 2 - 12, d a d u r c h
g e k e n n z e i c h n e t, daß die Anzeigevorrichtung (24) getrennte Anzeigefelder (30,31) für
die physikalische Zustandsanzeige und für die Ladezustandsanzeige des Prüflings (10) aufweist, die
von dem Operator (18) selektiv angesteuert werden.

-.-.-.-.-.-.-

Fig. 1

0022450

Fig. 2

# EUROPÄISCHER RECHERCHENBERICHT

**0022450**
Nummer der Anmeldung

EP 80 10 1949.8

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - B2 - 2 244 285 (K.S. CHAMPLIN) <br> * Spalte 4, Zeile 52 bis Spalte 6, Zeile 47 * <br> -- | 1,2 |
| | BE - A - 776 529 (VARTA S.P.A. et al.) <br> * Seite 5, Absatz 4; Fig. 9 * <br> -- | 2,3 |
| | RESEARCH DISCLOSURE , Nr. 167, März 1978 <br> "Battery Condition Status Indicator" <br> Seite 14, Referenz 16717 <br> ---- | 2,3, 11 |

**KLASSIFIKATION DER ANMELDUNG (Int.Cl.3)**

G 01 R 31/36

H 01 M 10/48

**RECHERCHIERTE SACHGEBIETE (Int. Cl.3)**

G 01 R 31/00

G 01 R 31/36

H 01 M 10/48

H 02 J 7/10

H 02 J 7/14

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 20-10-1980 | LEMMERICH |

EPA form 1503.1  06.78